(19) Europäisches Patentamt
European Patent Office
Office européen des brevets

(11) EP 0 689 557 B1

(12) **EUROPÄISCHE PATENTSCHRIFT**

(45) Veröffentlichungstag und Bekanntmachung des Hinweises auf die Patenterteilung:
**27.05.1998 Patentblatt 1998/22**

(21) Anmeldenummer: **94911147.0**

(22) Anmeldetag: **10.03.1994**

(51) Int Cl.[6]: **C08G 59/14**, C08G 59/40, C08G 59/50, H05K 1/03

(86) Internationale Anmeldenummer:
**PCT/EP94/00747**

(87) Internationale Veröffentlichungsnummer:
**WO 94/21703 (29.09.1994 Gazette 1994/22)**

(54) **EPOXIDHARZMISCHUNGEN**

EPOXY RESIN MIXTURES

MELANGES DE RESINES EPOXY

(84) Benannte Vertragsstaaten:
**AT BE CH DE FR GB IT LI NL SE**

(30) Priorität: **15.03.1993 DE 4308187**

(43) Veröffentlichungstag der Anmeldung:
**03.01.1996 Patentblatt 1996/01**

(73) Patentinhaber:
- **SIEMENS AKTIENGESELLSCHAFT 80333 München (DE)**
- **HOECHST AKTIENGESELLSCHAFT 65926 Frankfurt am Main (DE)**

(72) Erfinder:
- **GENTZKOW, Wolfgang von D-91077 Kleinsendelbach (DE)**
- **HUBER, Jürgen D-91058 Erlangen (DE)**
- **KAPITZA, Heinrich D-90765 Fürth (DE)**
- **ROGLER, Wolfgang D-91096 Möhrendorf (DE)**
- **KLEINER, Hans-Jerg D-61476 Kronberg (DE)**
- **WILHELM, Dieter D-91301 Forchheim (DE)**

(74) Vertreter: **Fuchs, Franz-Josef, Dr.-Ing. et al Postfach 22 13 17 80503 München (DE)**

(56) Entgegenhaltungen:
**EP-A- 0 384 939** **EP-A- 0 384 940**
**WO-A-94/21706**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft Epoxidharzmischungen zur Herstellung von Prepregs und Verbundwerkstoffen sowie aus diesen Epoxidharzmischungen hergestellte Prepregs und Verbundwerkstoffe.

Verbundwerkstoffe auf der Basis von Epoxidharzen und anorganischen oder organischen Verstärkungsmaterialien haben in vielen Bereichen der Technik und des täglichen Lebens eine hohe Bedeutung erlangt. Gründe dafür sind einerseits die relativ einfache und sichere Verarbeitung der Epoxidharze und andererseits das gute mechanische und chemische Eigenschaftsniveau der gehärteten Epoxidharz-Formstoffe, das eine Anpassung an unterschiedliche Einsatzzwecke und eine vorteilhafte Nutzung der Eigenschaften aller am Verbund beteiligten Werkstoffe gestattet.

Die Verarbeitung der Epoxidharze zu Verbundwerkstoffen erfolgt vorteilhaft über die Herstellung von Prepregs. Zu diesem Zweck werden anorganische oder organische Verstärkungsmaterialien bzw. Einlagerungskomponenten in Form von Fasern, Vliesen und Geweben oder von Flächenstoffen mit dem Harz getränkt. In den meisten Fällen geschieht dies mit einer Lösung des Harzes in einem leicht verdampf- oder verflüchtigbaren Lösungsmittel. Die dabei erhaltenen Prepregs dürfen nach diesem Prozeß nicht mehr klebend, aber auch noch nicht ausgehärtet sein, vielmehr soll sich die Harzmatrix lediglich in einem vorpolymerisierten Zustand befinden. Außerdem müssen die Prepregs ausreichend lagerstabil sein. So wird beispielsweise für die Herstellung von Leiterplatten eine Lagerstabilität von mindestens drei Monaten gefordert. Bei der Weiterverarbeitung zu Verbundwerkstoffen müssen die Prepregs außerdem bei Temperaturerhöhung aufschmelzen und sich mit den Verstärkungsmaterialien bzw. Einlagerungskomponenten sowie mit den für den Verbund vorgesehenen Werkstoffen unter Druck möglichst fest und dauerhaft verbinden, d.h. die vernetzte Epoxidharzmatrix muß eine hohe Grenzflächenhaftung zu den Verstärkungsmaterialien bzw. Einlagerungskomponenten sowie zu den zu verbindenden Materialien, wie metallischen, keramischen, mineralischen und organischen Materialien, ausbilden.

Im gehärteten Zustand wird von den Verbundwerkstoffen generell hohe mechanische und thermische Festigkeit sowie chemische Beständigkeit und Wärmeformbeständigkeit bzw. Alterungsbeständigkeit gefordert. Für elektrotechnische und elektronische Anwendungen kommt die Forderung nach dauerhaft hohen elektrischen Isolationseigenschaften und für spezielle Einsatzzwecke eine Vielzahl von zusätzlichen Forderungen hinzu. Für den Einsatz als Leiterplattenmaterial sind beispielsweise hohe Dimensionsstabilität über einen weiten Temperaturbereich, gutes Haftvermögen zu Glas und Kupfer, hoher Oberflächenwiderstand, geringer dielektrischer Verlustfaktor, gutes Bearbeitungsverhalten (Stanzbarkeit, Bohrbarkeit), geringe Wasseraufnahme und hohe Korrosionsbeständigkeit erforderlich.

Mit zunehmender Belastung und intensiver Nutzung der Verbundwerkstoffe erhält vor allem die Forderung nach Wärmeformbeständigkeit besonderes Gewicht. Dies bedeutet, daß die Materialien während der Verarbeitung und Nutzung hohen Temperaturen ohne Verformung oder Schädigung des Verbundes, beispielsweise durch Delaminierung, widerstehen müssen. Leiterplatten werden beispielsweise beim Schwallöten einer Temperatur von 270°C ausgesetzt. Ebenso können beim Schneiden und Bohren örtlich kurzzeitig Temperaturen von über 200°C auftreten. Ein günstiges Verhalten zeigen dabei Materialien mit einer hohen Glasübergangstemperatur $T_G$. Liegt diese über den genannten Werten, so ist im gesamten bei der Bearbeitung überstrichenen Temperaturbereich Formstabilität gewährleistet und Schädigungen, wie Verwölbung und Delaminierung, sind weitgehend ausgeschlossen. Das derzeit weltweit für FR4-Laminate im großen Maßstab eingesetzte Epoxidharz weist nach der Härtung eine Glasübergangstemperatur von nur 130°C auf. Dies führt aber zu den beschriebenen Schädigungen und Ausfällen bei der Fertigung. Es besteht daher schon lange der Wunsch, vergleichbar gut verarbeitbare und kostengünstige Materialien mit einer Glasübergangstemperatur von über etwa 180°C zur Verfügung zu haben.

Eine weitere Forderung, die in letzter Zeit zunehmende Bedeutung erlangt, ist die Forderung nach Schwerbrennbarkeit. In vielen Bereichen kommt dieser Forderung - wegen der Gefährdung von Menschen und Sachwerten - erste Priorität zu, beispielsweise bei Konstruktionswerkstoffen für den Flugzeug- und Kraftfahrzeugbau und für öffentliche Verkehrsmittel. Bei den elektrotechnischen und insbesondere den elektronischen Anwendungen ist die Schwerbrennbarkeit von Leiterplattenmaterialien - wegen der hohen Werte der darauf montierten elektronischen Bauelemente - unverzichtbar.

Zur Beurteilung des Brennverhaltens muß deshalb eine der härtesten Materialprüfnormen bestanden werden, nämlich die V-O-Einstufung nach UL 94V. Bei dieser Prüfung wird ein Prüfkörper vertikal am unteren Rand mit einer definierten Flamme beflammt. Die Summe der Brennzeiten von 10 Prüfungen darf 50 s nicht überschreiten. Diese Forderung ist schwer zu erfüllen, vor allem wenn es, wie in der Elektronik üblich, um dünne Wandstärken geht. Das weltweit im technischen Einsatz für FR4-Laminate befindliche Epoxidharz erfüllt diese Forderungen nur, weil es, auf das Harz bezogen, ca. 30 bis 40 % kernbrcmierte aromatische Epoxid-Komponenten enthält, d.h. ca. 17 bis 21 % Brom. Für andere Einsatzzwecke werden vergleichbar hohe Konzentrationen an Halogenverbindungen eingesetzt und oft noch mit Antimontrioxid als Synergist kombiniert. Die Problematik bei diesen Verbindungen besteht darin, daß sie einerseits zwar als Flammschutzmittel hervorragend wirksam sina, andererseits aber auch sehr bedenkliche Eigenschaften besitzen. So steht Antimontrioxid auf der Liste der krebserzeugenden Chemikalien, und aromatische Bromverbindungen spalten bei der thermischen Zersetzung nicht nur Bromradikale und Bromwasserstoff ab, die zu starker

Korrosion führen, bei der Zersetzung in Gegenwart von Sauerstoff können insbesondere die hochbromierten Aromaten vielmehr auch die hochtoxischen Polybromdibenzofurane und Polybromdibenzodioxine bilden. Erhebliche Schwierigkeiten bereitet desweiteren die Entsorgung von bromhaltigen Altwerkstoffen.

Materialien, die der Forderung nach erhöhter Wärmeformbeständigkeit entgegenkommen oder diese sogar erfüllen, sind beispielsweise Formstoffe auf der Basis Bismaleinimid/Triazin (BT) mit einer $T_G$ von ca. 200°C oder Polyimid (PI) mit einer $T_G$ von 260 bis 270°C. Neuerdings werden auch BT/Epoxy-Blends mit einer $T_G$ von 180°C angeboten. Mit diesen Harzsystemen hergestellte Laminate zeigen jedoch ein schlechteres Ver- und Bearbeitungsverhalten als Laminate auf Epoxidharzbasis. So erfordert beispielsweise die Herstellung von Laminaten auf Polyimidbasis Preßtemperaturen von ca. 230°C und wesentlich längere Nachhärtezeiten (ca. 8 h) bei Temperaturen von 230°C. Ein weiterer wesentlicher Nachteil dieser Harzsysteme ist ihr 6- bis 10mal höherer Materialpreis.

Ein vergleichsweise kostengünstiges Harzsystem wird erhalten, wenn aromatische und/oder heterocyclische Polyepoxidharze, d.h. Polyglycidylverbindungen, mit aromatischen Polyaminen als Härter kombiniert werden. Derartige Polyamine, die beispielsweise aus der DE-PS 27 43 680 bekannt sind, führen zu besonders wärmeformbeständigen, alterungsstabilen Netzwerkpolymeren. Der EP-PS 0 274 646 ist zu entnehmen, daß bei Verwendung von 1,3,5-Tris (3-amino-4-alkylphenyl)-2,4,6-trioxo-hexahydrotriazinen als Härter Laminate erhalten werden, die Glasübergangstemperaturen bis 245°C aufweisen und sich durch ein gutes Ver- und Bearbeitungsverhalten auszeichnen.

Auch wenn die genannten Harzsysteme ein recht unterschiedliches Brennverhalten aufweisen, gilt für alle der Nachteil, inhärent nicht ausreichend schwerbrennbar zu sein. Zur Erfüllung der für viele Einsatzzwecke unverzichtbaren Forderung, die Brennbarkeitsprüfung nach UL 94V mit der Einstufung V-O zu bestehen, kann deshalb auf den Einsatz von hochwirksamen bromhaltigen Flammschutzmitteln nicht verzichtet werden. Dies hat zur Folge, daß einerseits das mit Bromverbindungen verbundene Gefährdungspotential und andererseits eine durch die Bromverbindungen hervorgerufene Verschlechterung des thermisch-mechanischen Eigenschaftsniveaus in Kauf genommen werden muß.

Aus diesen Gründen hat es nicht an Versuchen gefehlt, die bromhaltigen Flammschutzmittel durch weniger problematische Substanzen zu ersetzen. So wurden beispielsweise Füllstoffe mit Löschgaswirkung, wie Aluminiumoxidhydrate (siehe: "J. Fire and Flammability", Vol. 3 (1972), Seiten 51 ff.), basische Aluminiumcarbonate (siehe: "Plast. Engng.", Vol. 32 (1976), Seiten 41 ff.) und Magnesiumhydroxide (EP-OS 0 243 201), sowie verglasende Füllstoffe, wie Borate (siehe: "Modern Plastics", Vol. 47 (1970), No. 6, Seiten 140 ff.) und Phosphate (US-PS 2 766 139 und 3 398 019), vorgeschlagen. Allen diesen Füllstoffen haftet aber der Nachteil an, daß sie die mechanischen, chemischen und elektrischen Eigenschaften der Verbundwerkstoffe zum Teil erheblich verschlechtern. Außerdem erfordern sie spezielle, meist aufwendigere Verarbeitungstechniken, da sie zur Sedimentation neigen und die Viskosität des gefüllten Harzsystems erhöhen.

Es ist auch schon die flammhemmende Wirksamkeit von rotem Phosphor beschrieben worden (GB-PS 1 112 139), gegebenenfalls in Kombination mit feinstverteiltem Siliciumdioxid oder Aluminiumoxidhydrat (US-PS 3 373 135). Dabei werden Werkstoffe erhalten, die - wegen der in Gegenwart von Feuchtigkeit entstehenden Phosphorsäure und der damit verbundenen Korrosion - den Einsatz für elektrotechnische und elektronische Zwecke einschränken. Desweiteren wurden bereits organische Phosphorverbindungen, wie Phosphorsäureester, Phosphonsäureester und Phosphine, als flammhemmende Additive vorgeschlagen (siehe: W.C. Kuryla und A.J. Papa "Flame Retardancy of Polymeric Materials", Vol. 1, Seiten 24 bis 38 und 52 bis 61, Marcel Dekker Inc., New York, 1973). Da diese Verbindungen für ihre "weichmachenden" Eigenschaften bekannt sind und als Weichmacher für Polymere weltweit in großem Maßstab verwendet werden (GB-PS 10 794), ist auch diese Alternative wenig erfolgversprechend.

Zur flammhemmenden Einstellung von Epoxidharzen können auch organische Phosphorverbindungen, wie epoxidgruppenhaltige Phosphorverbindungen, dienen, die im Epoxidharz-Netzwerk verankerbar sino. So sino aus der EP-OS 0 384 940 Epoxidharzmischungen bekannt, die kommerziell erhältliches Epoxidharz, das bereits erwähnte aromatische Polyamin 1,3,5-Tris(3-amino-4-alkylphenyl)-2,4,6-trioxo-hexahydrotriazin und eine epoxidgruppenhaltige Phosphorverbindung auf der Basis von Glycidylphosphat, Glycidylphosphonat oder Glycidylphosphinat enthalten. Mit derartigen Epoxidharzmischungen lassen sich ohne Halogenzusatz schwerbrennbare, nach UL 94V-0 einstufbare Laminate bzw. Verbundwerkstoffe herstellen, die eine Glasübergangstemperatur von > 200°C aufweisen. Zudem lassen sich diese Epoxidharzmischungen vergleichbar den im Einsatz befindlichen Epoxidharzen verarbeiten.

Es ist allgemein bekannt, daß bei Laminaten mit hoher Glasübergangstemperatur, beispielsweise auf Basis von Polyimid- oder BT-Harzen, die interlaminare Haftung sowie die Cu-Haftung geringer ist als bei den heutzutage überwiegend eingesetzten halogenhaltigen FR4-Laminaten; dies gilt auch für die in der EP-OS 0 384 940 beschriebenen Laminate. Ein sehr großer Anteil der derzeit hergestellten Leiterplatten sind sogenannte Multilayer-Leiterplatten (ML). Diese enthalten eine Vielzahl von Leiterebenen, die durch Epoxidharzverbünde gegeneinander distanziert und isoliert sind. Der Trend in der ML-Technik geht nun aber zu einer immer höheren Anzahl von Leiterebenen; so werden heute ML mit mehr als 20 Leiterebenen gefertigt. Da eine zu hohe Gesamtdicke der ML aus technischen Gründen vermieden werden muß, wird der Abstand zwischen den Leiterebenen immer geringer und damit die interlaminare Haftung und die Cu-Haftung bei ML-Laminaten mit hoher Glasübergangstemperatur immer problematischer.

In der Leiterplattentechnik wird die interlaminare Haftung meist indirekt bestimmt. Ein verbreitet angewendeter Test hierfür ist der Measling-Test, der bei Leiterplatten bestanden werden muß. Dabei wird ein Laminat ohne Kupferkaschierung mit einer Zinnchloridlösung und anschließend mit Wasser bei erhöhter Temperatur behandelt und nachfolgend 20 s in ein 260°C heißes Lötbad getaucht. Das Laminat wird dann visuell auf Delaminierung geprüft. Bei Laminierharzen mit hohen Glasübergangstemperaturen (180°C und höher) wird dieser Test bei den zunehmend dünneren Kernaufbauten, wie sie heute in der ML-Technik verwendet werden, nicht mehr bestanden, weil die interlaminare Haftung für diese dünnen Laminate nicht ausreichend ist. Weitere Schwierigkeiten aufgrund zu geringer interlaminarer Haftung ergeben sich bei der weiteren Verarbeitung von Elektrolaminaten, beispielsweise beim Bohren und Fräsen; deshalb müssen die Bohr- und Fräßgeschwindigkeiten - im Vergleich zu FR4-Material - vermindert werden.

Es besteht daher ein großer Bedarf an Elektrolaminaten, die zum einen, wie schon beschrieben, die geforderte Flammwidrigkeit halogenfrei erreichen und zum anderen eine hohe Glasübergangstemperatur bei gleichzeitig guter interlaminarer Haftung - auch bei extrem dünnen Kernaufbauten - besitzen. Eine Kombination dieser Eigenschaften ist bislang nicht in befriedigender Weise erreicht worden, vor allem nicht für extrem dünne Laminate, wie sie in der ML-Technik eingesetzt werden.

Aufgabe der Erfindung ist es, technisch einfache und damit kostengünstig zugängliche Epoxidharzmischungen anzugeben, die vergleichbar den im technischen Einsatz befindlichen Epoxidharzen verarbeitbar und zur Herstellung von Prepregs und Laminaten für die Multilayertechnik geeignet sind, welche ohne Halogenzusatz schwerbrennbare, d.h. nach UL 94V-0 einstufbare Formstoffe mit einer möglichst hohen Glasübergangstemperatur (≥ 180°C) ergeben und gleichzeitig eine verbesserte, zum Aufbau von ML-Kernen ausreichende interlaminare Haftung und Cu-Haftung aufweisen.

Dies wird erfindungsgemäß dadurch erreicht, daß die Epoxidharzmischungen folgende Komponenten enthalten:

- ein phosphormodifiziertes Epoxidharz mit einem Epoxidwert von 0,02 bis 1 mol/100 g, erhältlich durch Umsetzung von

  (A) Polyepoxidverbindungen mit mindestens zwei Epoxidgruppen pro Molekül mit
  (B) Phosphinsäure- und/oder Phosphonsäureanhydriden oder Phosphonsäurehalbestern und nachfolgende thermische Abspaltung von Alkohol, und

- ein aromatisches Polyamin folgender Struktur als Härter:

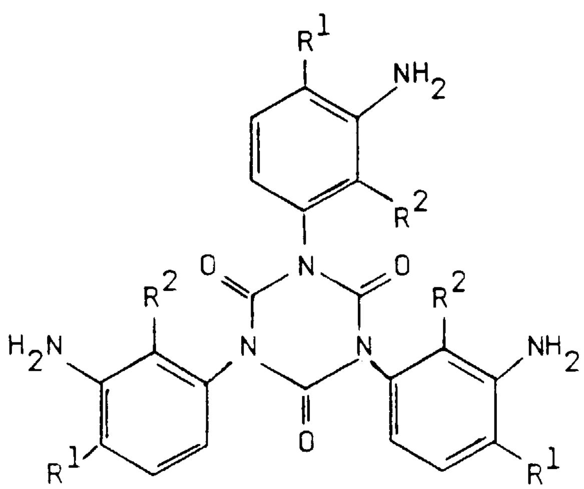
,

wobei an jeder der drei aromatischen Partialstrukturen jeweils einer der Reste $R^1$ und $R^2$ H und der andere Alkyl bedeutet.

Die phosphormodifizierten Epoxidharze werden durch Umsetzung von handelsüblichen Polyepoxidharzen (Polyglycidylharzen) mit folgenden Phosphorverbindungen hergestellt:

- Phosphinsäureanhydride: Anhydride von Phosphinsäuren mit Alkyl-, Alkenyl-, Cycloalkyl-, Aryl- oder Aralkylresten;
- Bis-phosphinsäureanhydride: Anhydride von Bis-phosphinsäuren, insbesondere von Alkan-bis-phosphinsäuren mit 1 bis 10 Kohlenstoffatomen in der Alkangruppierung;

- Phosphonsäureanhydride: Anhydride von Phosphonsäuren mit Alkyl-, Alkenyl-, Cycloalkyl-, Aryl- oder Aralkylresten.

Phosphormodifizierte Epoxidharze der vorstehend genannten Art sowie ein Verfahren zu deren Herstellung sind Gegenstand der gleichzeitig eingereichten internationalen Patentanmeldung Akt.Z. PCT/EP 94/00748 - "Phosphormodifizierte Epoxidharze, Verfahren zu ihrer Herstellung sowie deren Verwendung" (GR 93 P 8506 P).

Fhosphormodifizierte Epoxidharze können auch in der Weise hergestellt werden, daß die Polyepoxidverbindungen - anstelle von Phosphonsäureanhydriden - mit Phosphonsäurehalbestern umgesetzt werden und aus den dabei erhaltenen Produkten bei Temperaturen von mindestens 80°C Alkohol abgespaltet wird.

Zur Herstellung der phosphormodifizierten Epoxidharze können generell sowohl aliphatische als auch aromatische Glycidylverbindungen sowie deren Mischungen verwendet werden. Bevorzugt werden Bisphenol-A-diglycidylether, Bisphenol-F-diglycidylether, Polyglycidylether von Phenol/Formaldehyd- und Kresol/Formaldehyd-Novolaken, Diglycidylester von Phthal-, Tetrahydrophthal-, Isophthal- und Terephthalsäure sowie Mischungen aus diesen Epoxidharzen eingesetzt. Weitere verwendbare Polyepoxide sind beispielsweise hydrierte Bisphenol-A- und Bisphenol-F-diglycidylether, Hydantoin-Epoxidharze, Triglycidylisocyanurat, Triglycidyl-p-aminophenol, Tetraglycidyldiaminodiphenylmethan, Tetraglycidyldiaminodiphenylether, Tetrakis(4-glycidoxyphenyl)-ethan, Uracil-Epoxidharze, oxazolidinonmodifizierte Epoxidharze und Epoxide, die im "Handbook of Epoxy Resins" von Henry Lee und Kris Neville, McGraw-Hill Book Company 1967, und in der Monographie von Henry Lee "Epoxy Resins", American Chemical Society 1970, beschrieben sind. Das mittlere Molekulargewicht $\overline{M}_n$ der Polyepoxidverbindungen beträgt im allgemeinen 150 bis 4000, vorzugsweise 300 bis 1800.

Je nach Wahl des Ausgangsmolverhältnisses Phosphorverbindung:Epoxidharz lassen sich phosphormodifizierte Epoxidharze mit unterschiedlichem Epoxidgehalt und damit unterschiedlichem Phosphorgehalt herstellen. Zur Herstellung von Laminaten werden dabei phosphormodifizierte Epoxidharze mit im Mittel einer Epoxidgruppe pro Molekül eingesetzt, bevorzugt jedoch mit zwei Epoxidgruppen. Allgemein wird das Ausgangsmolverhältnis so gewählt, daß die Umsetzungsprodukte 0,5 bis 13 Masse-% Phosphor enthalten. Vorzugsweise beträgt der Phosphorgehalt 1 bis 8 %, insbesondere 2 bis 5 %. Der Phosphorgehalt der Epoxidharzmischung insgesamt sollte 0,5 bis 6 Masse-% betragen, vorzugsweise 1 bis 4 %.

Die Epoxidharzmischungen nach der Erfindung können zusätzlich ein phosphorfreies aromatisches und/oder heterocyclisches Epoxidharz enthalten; diesem Epoxidharz kann auch ein cycloaliphatisches Epoxidharz zugemischt sein. Im allgemeinen können bis zu 80 Masse-% des phosphormodifizierten Epoxidharzes durch phosphorfreies Epoxidharz ersetzt sein.

Der Zusatz des phosphorfreien Epoxidharzes dient zur Erzielung bestimmter Eigenschaften der aus aen erfindungsgemäßen Epoxidharzmischungen hergestellten Laminate. Das Mischungsverhältnis der beiden Komponenten wird bestimmt durch die Forderung nach einer Flammwidrigkeit gemäß UL 94V-0 bei 1,6 mm Schichtstärke. Dies bedeutet, daß die phosphorfreie Komponente nur in einem Maße zugemischt werden darf, daß die Gesamtmischung noch soviel Phosphor enthält, daß die genannte Forderung erfüllt wird. Bei Epoxidharzen mit hohem Phosphorgehalt läßt sich deshalb mehr phosphorfreies Epoxidharz zumischen als bei Epoxidharzen mit niedrigem Phosphorgehalt.

Sowohl als zusätzliches phosphorfreies Polyepoxidharz als auch zur Herstellung der phosphormodifizierten Epoxidharze eignen sich insbesondere folgende Polyglycidylverbindungen: aromatische Polyglycidylether, wie Bisphenol-A-diglycidylether, Bisphenol-F-diglycidylether und Bisphenol-S-diglycidylether, Polyglycidylether von Phenol/Formaldehyd- und Kresol/Formaldehyd-Harzen, Resorcindiglycidylether, Tetrakis(p-glycidylphenyl)-ethan, Di- bzw. Polyglycidylester von Phthal-, Isophthal- und Terephthalsäure sowie von Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidyl-bis-(p-aminophenyl)-methan, Hydantoin-Epoxidharze und Uracil-Epoxidharze sowie Di- und Polyglycidylverbindungen von mehrwertigen aliphatischen Alkoholen, wie 1,4-Butandiol, Trimethylolpropan und Polyalkylenglykolen. Desweiteren sind auch oxazolidinonmodifizierte Epoxidharze geeignet. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung des phosphormodifizierten Epoxidharzes einzeln oder im Gemisch vorliegen. Bevorzugt wird als Polyepoxidharz ein epoxidierter Novolak verwendet.

Als Phosphorkomponente werden zur Herstellung der phosphormodifizierten Epoxidharze insbesondere folgende Verbindungen eingesetzt:

- Phosphinsäureanhydride: Dimethylphosphinsäureanhydrid, Methylethylphosphinsäureanhydrid, Diethylphosphinsäureanhydrid, Dipropylphosphinsäureanhydrid, Ethylphenylphosphinsäureanhydrid und Diphenylphosphinsäureanhydrid;
- Alkan-bis-phosphinsäureanhydride: Methan-1,1-bis-methylphosphinsäureanhydrid, Ethan-1,2-bis-methylphosphinsäureanhydrid, Ethan-1,2-bis-phenylphosphinsäureanhydrid und Butan-1,4-bis-methylphosphinsäureanhydrid;

- Phosphonsäureanhydride: Methanphosphonsäureanhydrid, Ethanphosphonsäureanhydrid, Propanphosphonsäureanhydrid, Hexanphosphonsäureanhydrid und Benzolphosphonsäureanhydrid.

Die Herstellung der phosphormodifizierten Epoxidharze erfolgt in der Weise, daß die Polyepoxidverbindungen mit den Phosphinsäure- bzw. Phosphonsäureanhydriden vorzugsweise in einem inerten Lösungs- bzw. Verdünnungsmittel oder - bei angepaßter Reaktionsführung - auch in Substanz umgesetzt werden. Die phosphormodifizierten Epoxidharze weisen ein mittleres Molekulargewicht $\overline{M}_n$ bis zu 10000 auf; vorzugsweise beträgt $\overline{M}_n$ 200 bis 5000 und insbesondere 400 bis 2000.

Die in den erfindungsgemäßen Epoxidharzmischungen als Härter dienenden aromatischen Polyamine sind zum Teil bereits bekannt. Polyamine der angegebenen Struktur mit $R^1$ = Alkyl und $R^2$ = H sind in der EP-OS 0 274 646 beschrieben. Sie werden durch Trimerisierung von 2,4-Diisocyanato-alkylbenzolen und nachfolgende Hydrolyse der verbleibenden Isocyanatgruppen hergestellt. Verbindungen mit $R^1$ = H und $R^2$ = Alkyl werden analog durch Trimerisierung von 2,6-Diisocyanato-alkylbenzolen und nachfolgende Hydrolyse erhalten. Als Härter können in den erfindungsgemäßen Epoxidharzmischungen sowohl Polyamine der beiden vorstehend genannten Arten als auch Gemische dieser Verbindungen verwendet werden. Darüber hinaus können auch Polyamine eingesetzt werden, die durch Trimerisierung von Gemischen aus 2,4- und 2,6-Diisocyanato-alkylbenzolen und nachfolgende Hydrolyse der Trimerisate erhalten werden. Derartige Gemische sind großtechnisch zugänglich und erlauben eine kostengünstige Herstellung der Härterkomponente.

Bei der Hydrolyse der isocyanatgruppenhaltigen Trimerisierungsprodukte kann es auch zu einer Reaktion zwischen Isocyanatgruppen und Aminogruppen kommen. Dabei werden, als Nebenprodukt der Hydrolysereaktion, heterocyclische Polyamine mit Harnstoffgruppierungen erhalten. Derartige Polyamine können in den erfindungsgemäßen Epoxidharzmischungen ebenfalls als additive Härterkomponente eingesetzt werden, d.h. im Gemisch mit dem eigentlichen Härter zum Einsatz gelangen. Neben dem eigentlichen Härter bzw. neben Härtergemischen der vorstehend genannten Art können in den Epoxidharzmischungen auch aromatische Polyamine anderer Art, wie 4,4'-Diaminodiphenylmethan und 4,4'-Diaminodiphenylsulfon, und/oder andere heterocyclische Polyamine eingesetzt werden. Der Anteil derartiger Polyamine im Härtergemisch beträgt im allgemeinen maximal 30 Masse-%.

Das Äquivalentverhältnis zwischen eingesetzter Epoxid-Funktion und eingesetzter Aminwasserstoff-Funktion kann bei den erfindungsgemäßen Epoxidharzmischungen 1:0,5 bis 1:1,1 betragen, vorzugsweise beträgt es 1:0,7 bis 1:0,9.

Die Epoxidharzmischungen nach der Erfindung können auch Beschleuniger enthalten, die bekanntermaßen bei der Härtung von Epoxidharzen eine wichtige Rolle spielen. Üblicherweise werden tertiäre Amine oder Imidazole verwendet. Als Amine eignen sich beispielsweise Tetramethylethylendiamin, Dimethyloctylamin, Dimethylaminoethanol, Dimethylbenzylamin, 2,4,6-Tris(dimethylaminomethyl)-phenol, N,N'-Tetramethyldiaminodiphenylmethan, N,N'-Dimethylpiperazin, N-Methylmorpholin, N-Methylpiperidin, N-Ethylpyrrolidin, 1,4-Diazabicyclo(2,2,2)-octan und Chinoline. Geeignete Imidazole sind beispielsweise 1-Methylimidazol, 2-Methylimidazol, 1,2-Dimethylimidazol, 1,2,4,5-Tetramethylimidazol, 2-Ethyl-4-methylimidazol, 1-Cyanoethyl-2-phenylimidazol und 1-(4,6-Diamino-s-triazinyl-2-ethyl)-2-phenylimidazol. Die Beschleuniger werden in einer Konzentration von 0,01 bis 2 Masse-%, vorzugsweise 0,05 bis 1 %, eingesetzt, jeweils bezogen auf die Epoxidharzmischung.

Zur Prepregherstellung werden die einzelnen Komponenten getrennt oder zusammen in kostengünstigen Lösungsmitteln, wie Aceton, Methylethylketon, Ethylacetat, Methoxyethanol, Dimethylformamid und Toluol, oder in Gemischen derartiger Lösungsmittel gelöst, gegebenenfalls zu einer Lösung vereinigt und auf gängigen Imprägnieranlagen verarbeitet, d.h. zum Tränken von Fasern aus anorganischen oder organischen Materialien, wie Glas, Metall, Mineralien, Kohlenstoff, Aramid, Polyphenylensulfid und Cellulose, sowie von daraus hergestellten Ceweben oder Vliesen oder zum Beschichten von Flächenstoffen, wie Folien aus Metallen oder Kunststoffen, eingesetzt. Gegebenenfalls können die Imprägnierlösungen auch weitere, die Flammwidrigkeit verbessernde halogenfreie Zusätze enthalten, die zum Teil homogen gelöst bzw. dispergiert sein können. Derartige Zusätze können beispielsweise Melamincyanurate, Melaminphosphate, pulverisiertes Polyetherimid, Polyethersulfon und Polyimid sein.

Zur Herstellung von Prepregs für die Leiterplattentechnik wird überwiegend Glasgewebe eingesetzt. Für Multilayer-Leiterplatten werden insbesondere Prepregs aus Glasgewebetypen mit einem Flächengewicht von 25 bis 200 g/m$^2$ eingesetzt. Mit Imprägnierlösungen der vorstehend genannten Art lassen sich auch Prepregs mit geringen Flächengewichten Anforderungsgemäß herstellen. Die imprägnierten oder beschichteten Verstärkungsmaterialien bzw. Einlagerungskomponenten werden bei erhöhter Temperatur getrocknet, wobei einerseits das Lösungsmittel entfernt wird und andererseits eine Vorpolymerisation des Imprägnierharzes erfolgt. Insgesamt ergibt sich auf diese Weise ein außerordentlich günstiges Verhältnis von Aufwana zu erzielbaren Eigenschaften.

Die erhaltenen Beschichtungen und Prepregs sind nicht-klebend und bei Raumtemperatur für die Dauer von drei Monaten und mehr lagerstabil, d.h. sie weisen eine ausreichende Lagerstabilität auf. Sie lassen sich bei Temperaturen

bis 220°C zu Verbundwerkstoffen verpressen, die sich durch hohe Glasübergangstemperaturen von ≥ 180°C und durch inhärente Schwerbrennbarkeit auszeichnen. Werden als Einlagerungsmaterial beispielsweise Glasgewebe mit einem Masseanteil von 60 bis 62 %, bezogen auf das Laminat, verwendet, so wird die Brennprüfung nach UL 94V - ohne Zusatz von Halogenverbindungen oder sonstigen flammhemmenden Zusatzstoffen, selbst bei Prüfkörpern mit einer Wandstärke von 1,6 mm oder sogar von 0,8 mm - mit einer sicheren V-O-Einstufung bestanden. Dabei erweist es sich als besonders vorteilhaft, daß keine korrosiven oder besonders toxischen Spaltprodukte gebildet werden und die Rauchentwicklung, im Vergleich zu anderen Polymerwerkstoffen, insbesondere zu bromhaltigen Epoxidharzformstoffen, stark vermindert ist.

Die ausgehärteten Verbundwerkstoffe zeichnen sich ferner durch einen über einen weiten Temperaturbereich konstant kleinen thermischen Ausdehnungskoeffizienten sowie durch hohe Chemikalienbeständigkeit, Korrosionsbeständigkeit, geringe Wasseraufnahme und sehr gute elektrische Eigenschaftswerte aus. Die Haftung zu den verstärkenden und zu verbindenden Materialien ist ausgezeichnet. Bei Verwendung von Verstärkungsmaterialien der genannten Art werden Prepregs für mechanisch hoch beanspruchbare Konstruktionswerkstoffe erhalten. Diese Konstruktionswerkstoffe eignen sich beispielsweise für Anwendungen im Maschinenbau, im Fahrzeugbau, in der Flugtechnik und in der Elektrotechnik, beispielsweise in Form von Prepregs für die Leiterplattenherstellung, insbesondere auch zur Herstellung von Multilayer-Schaltungen.

Von besonderem Vorteil für die Verwendung als Leiterplattenmaterial ist die hohe Haftfestigkeit von Leiterbahnen aus Kupfer, die hohe Delaminierfestigkeit und eine ausgezeichnete Bearbeitbarkeit, die sich beispielsweise beim bohren von Durchkontaktierungslöchern darin zeigt, daß einwandfreie Bohrungen bei geringem Bohrerverschleiß erhalten werden. Damit können Materialien, die unter Verwendung der erfindungsgemäßen Epoxidharzmischungen hergestellt werden, insbesondere mehrlagige Leiterplatten, in denen dünne Kerne mit weniger/gleich 100 µm Dicke zum Einsatz kommen, sicherer bzw. kostengünstiger gefertigt werden.

Anhand von Ausführungsbeispielen soll die Erfindung noch näher erläutert werden.

Beispiel 1

Herstellung von Prepregs mittels eines phosphonsäureanhydridmodifizierten Epoxidharzes

Eine Lösung von A Masseteilen (MT) eines Umsetzungsproduktes (Epoxidwert: 0,34 mol/100 g) aus einem epoxidierten Novolak (Epoxidwert: 0,56 mol/100 g, mittlere Funktionalität: 3,6) und Propanphosphonsäureanhydrid in G Masseteilen Methylethylketon und I Masseteilen Ethylacetat wird mit einer Lösung von E Masseteilen eines Polyamins, das durch Trimerisierung einer 4:1-Mischung aus Toluol-2,4-diisocyanat und Toluol-2,6-diisocyanat und nachfolgende Hydrolyse (zu einem Produkt mit einem $NH_2$-Wert von 9,35 %) hergestellt wurde, in G Masseteilen Methylethylketon und H Masseteilen Dimethylformamid versetzt. Mit der dabei erhaltenen Lösung werden Glasgewebe (Flächengewicht: 106 g/m$^2$) mittels einer Laborimprägnieranlage kontinuierlich imprägniert und in einer Vertikaltrockenanlage bei Temperaturen von 50 bis 160°C getrocknet. Derart hergestellte Prepregs sind klebfrei und bei Raumtemperatur (bei maximal 21°C und maximal 50 % relativer Luftfeuchte) lagerstabil. Die Zusammensetzung der Imprägnierharzlösung und die Eigenschaften der Prepregs sind Tabelle 1 zu entnehmen.

Beispiel 2

Herstellung von Prepregs mittels eines phosphonsäureanhydridmodifizierten Epoxidharzes

Es wird entsprechend Beispiel 1 verfahren, die Imprägnierharzlösung wird jedoch noch mit F Masseteilen 2-Methylimidazol versetzt. Die Zusammensetzung der Imprägnierharzlösung und die Eigenschaften der Prepregs sind Tabelle 1 zu entnehmen.

Mit der Imprägnierharzlösung wurde - neben dem Glasgewebe mit einem Flächengewicht von 106 g/m$^2$ - auch ein für dünnere Kernaufbauten geeignetes Glasgewebe (Flächengewicht: 48 g/m$^2$) imprägniert. Die Eigenschaften der dabei erhaltenen Prepregs sind ebenfalls Tabelle 1 zu entnehmen.

Beispiel 3

Herstellung von Prepregs mittels eines phosphonsäureanhydridmodifizierten Epoxidharzes und Bisphenol-F-diglycidylether

Eine Lösung von B Masseteilen eines Umsetzungsproduktes (Epoxidwert: 0,30 mol/100 g) aus einem epoxidierten Novolak (Epoxidwert: 0,50 mol/100 g, mittlere Funktionalität: 3,8) und Propanphosphonsäureanhydrid in G Masseteilen Methylethylketon und I Masseteilen Ethylacetat wird mit J Masseteilen Bisphenol-F-diglycidylether (Epoxidwert: 0,61

mol/100 g) und mit einer Lösung von E Masseteilen eines entsprechend Beispiel 1 hergestellten Polyamins ($NH_2$-Wert: 9,35 %) in G Masseteilen Methylethylketon und H Masseteilen Dimethylformamid versetzt. Der dabei erhaltenen Lösung werden F Masseteile 2-Methylimidazol zugesetzt, dann wird, wie in Beispiel 1 beschrieben, zu Prepregs verarbeitet. Die Prepregs sind nach der Trocknung klebfrei und bei Raumtemperatur mehr als drei Monate lagerstabil. Die Zusammensetzung der Imprägnierharzlösung und die Eigenschaften der Prepregs sind Tabelle 1 zu entnehmen.

Beispiel 4

Herstellung von Prepregs mittels eines phosphonsäureanhydridmodifizierten Epoxidharzes und eines oxazolidinonmodifizierten Epoxidharzes

Zu einer Lösung von A Masseteilen eines Umsetzungsproduktes (Epoxidwert: 0,34 mol/100 g) aus einem epoxidierten Novolak (Epoxidwert: 0,56 mol/100 g, mittlere Funktionalität: 3,6) und Propanphosphonsäureanhydrid in G Masseteilen Methylethylketon und I Masseteilen Ethylacetat werden eine 50 %ige Lösung von E Masseteilen eines entsprechend Beispiel 1 hergestellten Polyamins ($NH_2$-Wert: 9,35 %) in Methylethylketon/Dimethylformamid (2:1) und C Masseteile eines oxazolidinonmodifizierten Epoxidharzes (Epoxidwert: 0,21 mol/100 g) gegeben. Die dabei erhaltene Lösung wird mit F Masseteilen 2-Methylimidazol versetzt, dann wird, wie in Beispiel 1 beschrieben, zu Prepregs verarbeitet.

Die Prepregs sind nach der Trocknung klebfrei und bei Raumtemperatur mehr als drei Monate lagerstabil. Die Zusammensetzung der Imprägnierharzlösung und die Eigenschaften der Prepregs sind Tabelle 1 zu entnehmen.

Beispiel 5

Herstellung von Prepregs mittels eines phosphonsäureanhydridmodifizierten Epoxidharzes und eines OH-gruppenhaltigen oligomeren Epoxidharzes auf Basis von Bisphenol-A

Zu einer Lösung von A Masseteilen eines Umsetzungsproduktes (Epoxidwert: 0,34 mol/100 g) aus einem epoxidierten Novolak (Epoxidwert: 0,56 mol/100 g, mittlere Funktionalität: 3,6) und Propanphosphonsäureanhydrid in G Masseteilen Methylethylketon und I Masseteilen Ethylacetat und D Masseteilen eines oligomeren Epoxidharzes auf Basis Bisphenol-A-diglycidylether (Epoxidwert: 0,25 mol/100 g) wird eine 50 %ige Lösung von E Masseteilen eines entsprechend Beispiel 1 hergestellten Polyamins ($NH_2$-Wert: 9,35 %) in Methylethylketon/Dimethylformamid (2:1) gegeben. Die dabei erhaltene Lösung wird mit F Masseteilen 2-Methylimidazol versetzt, dann wird, wie in Beispiel 1 beschrieben, zu Prepregs verarbeitet. Die Prepregs sind nach der Trocknung klebfrei und bei Raumtemperatur mehr als drei Monate lagerstabil. Die Zusammensetzung der Imprägnierharzlösung und die Eigenschaften der Prepregs sind Tabelle 1 zu entnehmen.

Tabelle 1

| Beispiel Nr. Komponenten: | 1 | 2 | 3 | 4 | 5 |
|---|---|---|---|---|---|
| A (MT) | 77 | 77 | - | 60 | 63 |
| B (MT) | - | - | 68 | - | - |
| C (MT) | - | - | - | 20 | - |
| D (MT) | - | - | - | - | 16 |
| E (MT) | 23 | 23 | 22 | 20 | 21 |
| F (MT) | - | 0,2 | 0,2 | 0,2 | 0,2 |
| G (MT) | 49 | 49 | 50 | 54 | 50 |
| H (MT) | 10 | 10 | 7 | 9 | 9 |
| I (MT) | 6 | 6 | 10 | 5 | 5 |
| J (MT) | - | - | 10 | - | - |
| Meßwerte: Restgehalt an Lösungsmittel (%) | 0,2 | 0,2<br>0,2 | 0,2 | 0,1 | 0,2 |
| Restgelierzeit bei 170°C (s) | 127 | 107<br>115 | 80 | 120 | 125 |

Beispiel 6

Herstellung und Prüfung von Laminaten

Je 13 der nach den Beispielen 1 bis 5 hergestellten Prepregs (Glasgewebetyp 2116, Flächengewicht: 106 g/m$^2$) werden in einer Presse bei 175°C und 65 bar verpreßt. Die 1,5 bis 1,6 mm dicken Laminate werden nach 40 min aus der Presse entfernt und anschließend 2 h bei 200°C nachgetempert. An den auf diese Weise erhaltenen Körpern wird mittels dynamisch-mechanischer Analyse (DMTA) die Glasübergangstemperatur ($T_G$) und die Brennbarkeit nach UL 94V geprüft. Die dabei erhaltenen Werte sind in Tabelle 2 zusammengefaßt.

Tabelle 2

| Beispiel Nr. Meßwerte: | 1 | 2 | 3 | 4 | 5 |
|---|---|---|---|---|---|
| $T_G$ (°C) | 210 | 200 | 194 | 195 | 189 |
| mittlere Brenndauer nach UL 94V (s) | 4,9 | 3,5 | 4,2 | 4,7 | 4,9 |
| Einstufung | V-O | V-O | V-O | V-O | V-O |

Beispiel 7

Herstellung und Prüfung von Multilayer-Kernen

Entsprechend den Beispielen 1 bis 5 hergestellte Prepregs (Glasgewebetyp 2116, Flächengewicht: 106 g/m$^2$) werden zu Laminaten verpreßt, die aus zwei Lagen Prepregs, beidseitig kaschiert mit einer 35 µm Cu-Folie, aufgebaut sind (Preßparameter: 175°C, 60 bis 65 bar, 40 min), und dann wird 2 h bei 200°C nachgetempert. An den 0,30 bis 0,33 mm dicken Laminaten wird das Haftvermögen der Kupferfolie, der Measling-Test, die Lötbadbeständigkeit und die interlaminare Haftung bestimmt. Die dabei erhaltenen Werte sind Tabelle 3 zu entnehmen.

Tabelle 3

| Beispiel Nr. Meßwerte: | 1 | 2 | 3 | 4 | 5 |
|---|---|---|---|---|---|
| Haftvermögen der Cu-Folie bei RT (N/mm) | 1,9 | 2,0 | 1,7 | 2,0 | 2,0 |
| Measling-Test (LT26) | + | + | + | + | + |
| Interlaminare Haftung (N/mm) | 1,15 | 1,16 | 1,12 | 1,20 | 1,18 |
| Lötbadbeständigkeit bei 260°C/60 s | + | + | + | + | + |

Die an den Laminaten durchgeführten Tests verlaufen folgendermaßen:

- Wärmebeständigkeit auf dem Lötbad
  Die Prüfung erfolgt nach DIN IEC 249 Teil 1, Abschnitt 3.7, unter Verwendung eines Lötbades nach Abschnitt 3.7.2.3. Es sind Probekörper der Größe 25 mm x 100 mm zu verwenden, die mit der Kupferseite auf das Lötbad gelegt werden. Es darf keine Delaminierung sowie keine Bildung von Measlings, Flecken oder Blasen unter der Kaschierung auftreten.
- Haftvermögen der Kupferkaschierung
  Ein 25 mm breiter und 100 mm langer Streifen der Kupferfolie wird auf 20 mm Länge vom Glashartgewebe gelöst und mittels einer geeigneten Vorrichtung mit einer Abzugsgeschwindigkeit von 50 mm/min senkrecht abgezogen. Gemessen wird die hierzu erforderliche Kraft F (N).
- Prüfung der interlaminaren Haftung
  Ein 25 mm breiter und 100 mm langer Streifen der obersten Glashartgewebelage wird auf 20 mm Länge von der nächsten darunterliegenden Glashartgewebelage gelöst und mittels einer geeigneten Vorrichtung mit einer Abzugsgeschwindigkeit von 50 mm/min senkrecht abgezogen. Gemessen wird die hierzu erforderliche Kraft F (N).
- Measling-Test
  Die Prüfung erfolgt an Probekörpern der Größe 20 mm x 100 mm ohne Kupferkaschierung. Die Probekörper werden 3 min in eine 65°C heiße LT26-Lösung (Zusammensetzung: 850 ml entionisiertes $H_2O$, 50 ml HCl p.a., 100 g $SnCl_2 . 2\ H_2O$, 50 g Thioharnstoff) getaucht, mit fließendem Wasser abgespült und anschließend 20 min in kochendes Wasser gelegt. Nach dem Lufttrocknen der Probe (2 bis 3 min) wird diese 10 s in ein 260°C heißes Lötbad getaucht. Das Laminat darf dabei nicht delaminieren.

Beispiel 8

Entsprechend Beispiel 2 hergestellte Prepregs (Glasgewebetyp 1080, Flächengewicht: 48 g/m$^2$) werden zu einem Laminat verpreßt, das aus zwei Lagen Prepregs aufgebaut und beidseitig mit einer 35 µm Cu-Folie kaschiert ist. An dem 0,19 bis 0,21 mm dicken Laminat wird das Haftvermögen der Cu-Folie (bei RT) zu 1,7 N/mm und die interlaminare Haftung zu 1,09 N/mm bestimmt; der Measling-Test wird bestanden und die Lötbadbeständigkeit ist gegeben.

Beispiel 9

Herstellung von Prepregs und Laminaten mittels eines phosphormodifizierten Epoxidharzes

Eine Lösung von A Masseteilen eines phosphormodifizierten Epoxidharzes (Epoxidwert: 0,36 mol/100 g, Phosphorgehalt: 3,53 %), das durch Umsetzung eines epoxidierten Novolaks (Epoxidwert: 0,56 mol/100 g, mittlere Funktionalität: 3,6) mit Methanphosphonsäuremonomethylester und nachfolgende thermische Abspaltung von Methanol erhalten wurde, in G Masseteilen Methylethylketon und I Masseteilen Ethylacetat wird mit einer Lösung von E Masseteilen eines Polyamins entsprechend Beispiel 1 ($NH_2$-Wert: 9,35 %) in G Masseteilen Methylethylketon und H Masseteilen Dimethylformamid versetzt; dann werden noch F Masseteile 2-Methylimidazol zugesetzt. Mit der dabei erhaltenen Lösung werden Glasgewebe (Flächengewicht: 197 g/m$^2$) mittels einer Laborimprägnieranlage kontinuierlich imprägniert und in einer Vertikaltrockenanlage bei Temperaturen von 50 bis 160°C getrocknet. Derart hergestellte Prepregs sind klebfrei und bei Raumtemperatur (bei maximal 21°C und maximal 50 % relativer Luftfeuchte) lagerstabil. Die Zusammensetzung der Imprägnierharzlösung und die Eigenschaften der Prepregs sind Tabelle 4 zu entnehmen.

Je 8 der hergestellten Prepregs (Glasgewebetyp 7628, Flächengewicht: 197 g/m$^2$) werden in einer Presse bei 175°C und 65 bar verpreßt. Die 1,5 bis 1,6 mm dicken Laminate werden nach 40 min aus der Presse entfernt und anschließend 2 h bei 200°C nachgetempert. An den auf diese Weise erhaltenen Körpern wird mittels dynamisch-mechanischer Analyse (DMTA) die Glasübergangstemperatur ($T_G$) und die Brennbarkeit nach UL 94V geprüft. Die dabei erhaltenen Werte sind Tabelle 5 zu entnehmen.

Beispiel 10

Herstellung von Prepregs und Laminaten mittels eines phosphormodifizierten Epoxidharzes

Eine Lösung von B Masseteilen eines phosphormodifizierten Epoxidharzes (Epoxidwert: 0,35 mol/100 g, Phosphorgehalt: 3,57 %), das durch Umsetzung eines epoxidierten Novolaks (Epoxidwert: 0,56 mol/100 g, mittlere Funktionalität: 3,6) mit Propanphosphonsäuremonomethylester und nachfolgende thermische Abspaltung von Methanol erhalten wurde, in G Masseteilen Methylethylketon und I Masseteilen Ethylacetat wird mit einer Lösung von E Masseteilen eines Polyamins entsprechend Beispiel 1 ($NH_2$-Wert: 9,35 %) in G Masseteilen Methylethylketon und H Masseteilen Dimethylformamid versetzt; dann werden noch F Masseteile 2-Methylimidazol zugesetzt. Mit der dabei erhaltenen Lösung werden, wie in Beispiel 9 beschrieben, Prepregs hergestellt. Die Prepregs sind nach der Trocknung klebfrei und bei Raumtemperatur lagerstabil. Die Zusammensetzung der Imprägnierharzlösung und die Eigenschaften der Prepregs sind Tabelle 4 zu entnehmen.

Tabelle 4

| Beispiel Nr. Komponenten: | 9 | 10 |
|---|---|---|
| A(MT) | 55 | - |
| B(MT) | - | 56 |
| E(MT) | 11 | 11 |
| F(MT) | 0,2 | 0,2 |
| G(MT) | 10 | 10 |
| H(MT) | 11 | 12 |
| I(MT) | 5 | 4 |
| Meßwerte: Restgehalt an Lösungsmittel (%) | 0,2 | 0,3 |
| Restgelierzeit bei 170°C (s) | 110 | 130 |

Je 8 der hergestellten Prepregs werden - entsprechend eeispiel 9 - zu Laminaten verarbeitet und geprüft. Die an den getemperten Laminaten ermittelten Werte sind Tabelle 5 zu entnehmen.

Tabelle 5

| Beispiel Nr. Meßwerte: | 9 | 10 |
|---|---|---|
| $T_G$ (°C) | 209 | 186 |
| mittlere Brenndauer nach UL 94 V (s) | 3,8 | 4,6 |
| Einstufung | V-O | V-O |

## Patentansprüche

1. Epoxidharzmischungen zur Herstellung von Prepregs und Verbundwerkstoffen, **dadurch gekennzeichnet**, daß sie folgende Komponenten enthalten:

   - ein phosphormodifiziertes Epoxidharz mit einem Epoxidwert von 0,02 bis 1 mol/100 g, erhältlich durch Umsetzung von

     (A) Polyepoxidverbindungen mit mindestens zwei Epoxidgruppen pro Molekül mit
     (B) Phosphinsäure- und/oder Phosphonsaureanhydriden oder Phosphonsäurehalbestern und nachfolgende thermische Abspaltung von Alkohol, und

   - ein aromatisches Polyamin folgender Struktur als Härter:

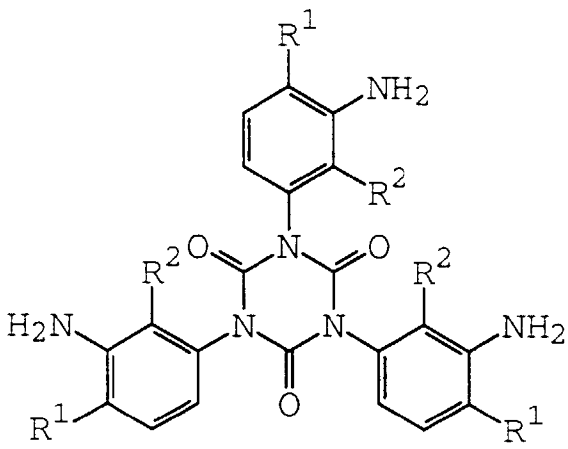

,

   wobei an jeder der drei aromatischen Partialstrukturen jeweils einer der Reste $R^1$ und $R^2$ H und der andere Alkyl bedeutet.

2. Epoxidharzmischungen nach Anspruch 1, **dadurch gekennzeichnet**, daß der Phosphorgehalt des phosphormodifizierten Epoxidharzes 0,5 bis 13 Masse-% beträgt, vorzugsweise 1 bis 8 Masse-%.

3. Epoxidharzmischungen nach Anspruch 1 oder 2, **dadurch gekennzeichnet**, daß sie zusätzlich ein phosphorfreies aromatisches und/oder heterocyclisches Epoxidharz enthalten, gegebenenfalls in Abmischung mit einem cycloaliphatischen Epoxidharz.

4. Epoxidharzmischungen nach Anspruch 3, **dadurch gekennzeichnet**, daß bis zu 80 Masse-% des phosphormodifizierten Epoxidharzes durch phosphorfreies Epoxidharz ersetzt sind.

5. Epoxidharzmischungen nach einem der Ansprüche 1 bis 4, **dadurch gekennzeichnet**, daß das Verhältnis zwischen Epoxid-Funktion und Aminwasserstoff-Funktion 1:0,5 bis 1:1,1 beträgt, vorzugsweise 1:0,7 bis 1:0,9.

6. Epoxidharzmischungen nach einem oder mehreren der Ansprüche 1 bis 5, **dadurch gekennzeichnet**, daß der Härter im Gemisch mit weiteren aromatischen und/oder heterocyclischen Polyaminen vorliegt.

7. Epoxidharzmischungen nach einem oder mehreren der Ansprüche 1 bis 6, **dadurch gekennzeichnet**, daß sie einen Beschleuniger enthalten.

8. Epoxidharzmischungen nach einem oder mehreren der Ansprüche 1 bis 7, **dadurch gekennzeichnet**, daß der Phosphorgehalt 0,5 bis 6 Masse-% beträgt, vorzugsweise 1 bis 4 Masse-%, jeweils bezogen auf die Harzmischung.

9. Prepregs und Verbundwerkstoffe auf der Basis von anorganischen oder organischen Verstärkungsmaterialien in Form von Fasern, Vliesen oder Geweben bzw. von Flächenstoffen, hergestellt aus Epoxidharzmischungen nach einem oder mehreren der Ansprüche 1 bis 8.

10. Leiterplatten aus Prepregs, hergestellt aus Glasfasergewebe und Epoxidharzmischungen nach einem oder mehreren der Ansprüche 1 bis 8.

## Claims

1. Epoxy resin mixtures for the production of prepregs and composite materials, characterized in that they contain the following components:

   - a phosphorus-modified epoxy resin having an epoxide value of 0.02 to 1 mol/100 g and obtainable by reacting

     (A) polyepoxy compounds having at least two epoxy groups per molecule with
     (B) phosphinic and/or phosphonic anhydrides or phosphonic half-esters and subsequent thermal elimination of alcohol, and

   - an aromatic polyamine having the following structure as a curing agent:

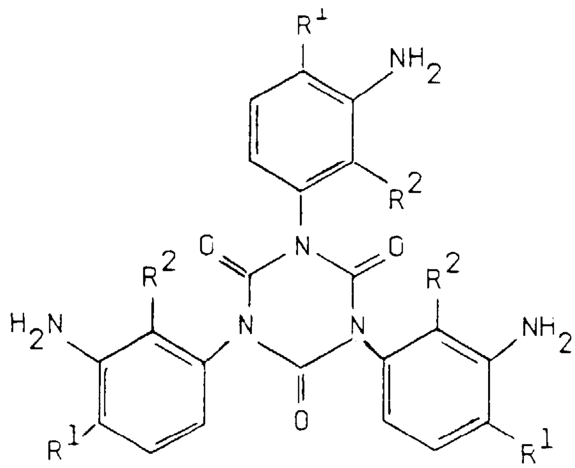

   where one of the radicals $R^1$ and $R^2$ denotes H and the other denotes alkyl on each of the three aromatic partial structures.

2. Epoxy resin mixtures according to Claim 1, characterized in that the phosphorus content of the phosphorus-modified epoxy resin is 0.5 to 13% by weight, preferably 1 to 8% by weight.

3. Epoxy resin mixtures according to Claim 1 or 2, characterized in that they additionally contain a phosphorus-free aromatic and/or heterocyclic epoxy resin, optionally as a mixture with a cycloaliphatic epoxy resin.

4. Epoxy resin mixtures according to Claim 3, characterized in that up to 80% by weight of the phosphorus-modified epoxy resin are replaced by phosphorus-free epoxy resin.

5. Epoxy resin mixtures according to any of Claims 1 to 4, characterized in that the ratio of epoxy function to amine hydrogen function is 1:0.5 to 1:1.1, preferably 1:0.7 to 1:0.9.

6. Epoxy resin mixtures according to one or more of Claims 1 to 5, characterized in that the curing agent is present as a mixture with further aromatic and/or heterocyclic polyamines.

7. Epoxy resin mixtures according to one or more of Claims 1 to 6, characterized in that they contain an accelerator.

8. Epoxy resin mixtures according to one or more of Claims 1 to 7, characterized in that the phosphorus content is 0.5 to 6% by weight, preferably 1 to 4% by weight, based in each case on the resin mixture.

9. Prepregs and composite materials based on inorganic or organic reinforcing materials in the form of fibres, nonwovens or woven fabrics or on sheet-like materials, produced from epoxy resin mixtures according to one or more of Claims 1 to 8.

10. Printed circuit boards comprising prepregs, produced from woven glass fabrics and epoxy resin mixtures according to one or more of Claims 1 to 8.

**Revendications**

1. Mélanges de résines époxydes pour préparer des préimprégnés et des matériaux composites, caractérisés en ce qu'ils contiennent les constituants suivants :

   - une résine époxyde modifiée par le phosphore, ayant une indice d'époxy de 0,02 à 1 mole/100 g, pouvant être obtenue par réaction

     (A) de composés polyépoxydiques ayant au moins deux groupes époxydes par molécule, avec
     (B) des anhydrides phosphiniques et/ou des anhydrides phosphoniques, ou encore des hémiesters d'acides phosphoniques, suivie d'une scission thermique d'un alcool, et

   - une polyamine aromatique, servant de durcisseur, ayant la structure suivante :

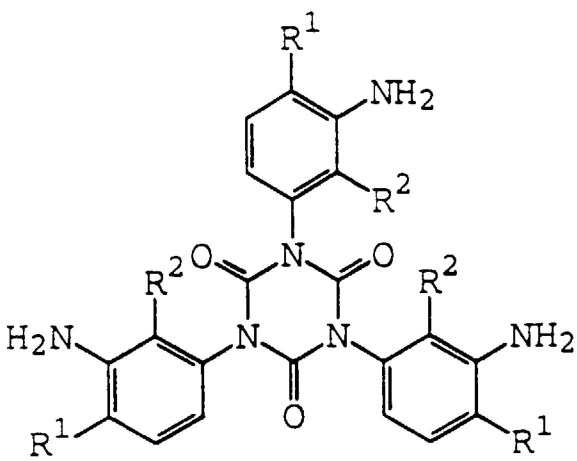

,

   où, sur chacune des trois structures partielles aromatiques, l'un des deux radicaux $R^1$ et $R^2$ est H, et l'autre est un groupe alcoyle.

2. Mélanges de résines époxydes selon la revendication 1, caractérisés en ce que la teneur en phosphore de la résine époxyde modifiée par un phosphore est de 0,5 à 13 % en masse, de préférence de 1 à 8 % en masse.

3. Mélanges de résines époxydes selon la revendication 1 ou 2, caractérisés en ce qu'ils contiennent, en outre, une résine époxyde aromatique et/ou hétérocyclique sans phosphore, éventuellement en mélange avec une résine époxyde cycloaliphatique.

4. Mélanges de résines époxydes selon la revendication 3, caractérisés en ce que jusqu'à 80 % en masse de la

résine époxyde modifiée par le phosphore sont remplacés par une résine époxyde sans phosphore.

5. Mélanges de résines époxydes selon l'une des revendications 1 à 4, caractérisés en ce que le rapport entre la fonction époxy et la fonction hydrogène d'amine est de 1:0,5 à 1:1,1, de préférence de 1:0,7 à 1:0,9.

6. Mélanges de résines époxydes selon l'une ou plusieurs des revendications 1 à 5, caractérisés en ce que le durcisseur est présent en mélange avec d'autres polyamines aromatiques et/ou hétérocycliques.

7. Mélanges de résines époxydes selon l'une ou plusieurs des revendications 1 à 6, caractérisés en ce qu'ils contiennent un accélérateur.

8. Mélanges de résines époxydes selon l'une ou plusieurs des revendications 1 à 7, caractérisés en ce que la teneur en phosphore est de 0,5 à 6 % en masse, de préférence de 1 à 4 % en masse, par rapport au mélange de résines.

9. Préimprégnés et matériaux composites à base de matériaux de renforcement inorganiques ou organiques sous forme de fibres, de tissus tissés ou non-tissés ou de structures bidimensionnelles, fabriqués à partir de mélanges de résines époxydes selon l'une ou plusieurs des revendications 1 à 8.

10. Cartes imprimées obtenues à partir de préimprégnés, fabriquées à partir de tissus de fibres de verre et de mélanges de résines époxydes selon l'une ou plusieurs des revendications 1 à 8.